(19) **Europäisches Patentamt / European Patent Office / Office européen des brevets**

(11) **EP 1 130 774 B1**

(12) **EUROPÄISCHE PATENTSCHRIFT**

(45) Veröffentlichungstag und Bekanntmachung des Hinweises auf die Patenterteilung:
**06.08.2008 Patentblatt 2008/32**

(51) Int Cl.:
**H03H 17/02** (2006.01)

(21) Anmeldenummer: **01104698.4**

(22) Anmeldetag: **26.02.2001**

(54) **Verfahren und Vorrichtung zur schaltungstechnischen Realisierung eines Rank Value Filters**

Method and device for the realisation of rank order filters

Méthode et dispositif pour la réalisation des filtres de N-ième rang

(84) Benannte Vertragsstaaten:
**AT BE CH CY DE DK ES FI FR GB GR IE IT LI LU MC NL PT SE TR**

(30) Priorität: **29.02.2000 DE 10009383**

(43) Veröffentlichungstag der Anmeldung:
**05.09.2001 Patentblatt 2001/36**

(73) Patentinhaber: **EADS Deutschland GmbH**
**81663 München (DE)**

(72) Erfinder:
• **Gessler, Ralf**
**88255 Baienfurt (DE)**
• **Kölle, Hans-Georg**
**89188 Merklingen (DE)**
• **Pfleiderer, Hans-Jörg, Prof. Dr.**
**89075 Ulm (DE)**

(74) Vertreter: **Meel, Thomas**
**Patentassessor,**
**c/o Dornier GmbH**
**L H G**
**88039 Friedrichshafen (DE)**

(56) Entgegenhaltungen:
**US-A- 4 649 394**

• **JENQ-NENG HWANG ET AL: "SYSTOLIC ARCHITECTURES FOR RADAR CFAR DETECTORS" IEEE TRANSACTIONS ON SIGNAL PROCESSING, IEEE, INC. NEW YORK, US, Bd. 39, Nr. 10, 1. Oktober 1991 (1991-10-01), Seiten 2286-2295, XP000264190 ISSN: 1053-587X**

**Beschreibung**

Die Erfindung betrifft ein Verfahren und eine Vorrichtung zur schaltungstechnischen Realisierung eines Rank Value Filters gemäß den Merkmalen der Ansprüche 1 und 8.

Die Aufgabe eines Radarempfängers besteht darin, ein empfangenes Signal auszuwerten und gegebenenfalls ein Ziel zu melden. Das abgestrahlte Radarsignal wird jedoch nicht nur von dem zu detektierenden Ziel, sondern auch von unerwünschten Objekten, dem Clutter reflektiert. Ein Clutter kann beispielsweise durch Regenwolken oder dem Erdboden verursacht werden. Um beim Eintritt in solche Cluttergebiete die Falschalarmwahrscheinlichkeit annähernd konstant zu Halten werden im allgemeinen CFAR (Constant False Alarm Rate) -Verfahren angewandt.

Ein spezielles CFAR-Verfahren ist die Ordered Statistik-CFAR (OS-CFAR). Zur Durchführung dieses Verfahrens wird ein Rank Value Filter verwendet.

Die US-A-4 649 394 beschreibt ein Verfahren sowie eine zur Durchführung geeignete Vorrichtung zur schnellen Sortierung der Werte einer Wertegruppe, wobei in aufeinanderfolgenden Zyklen jeweils der älteste Wert der Wertegruppe durch einen neuen Wert ersetzt wird, und Ordnen der Werte der Größe nach zu einer Rankfolge. Zur Rangordnung wird jedem Wert der Wertegruppe ein Rank zugeordnet, der in einem inkrementier- und dekrementierbaren Rangzähler gespeichert wird.

Aufgabe der Erfindung ist es eine weitere Vorrichtung und ein dafür geeignetes Verfahren zur schaltungstechnischen Realisierung eines Rank Value Filters zu schaffen.

Die Aufgabe wird durch ein Verfahren gelöst, welches auf der Sortiermethode des 'Löschen und Einfügen' basiert, und bei welchem die zu sortierenden Daten der Größe nach geordnet in einem Schieberegister $a[]$ vorliegen. Zur Durchführung des Verfahrens wird die Richtung bestimmt, in welche die im Schieberegister $a[]$ gespeicherten Daten geschoben werden, um für die Einsortierung eines neuen Datums $v/$Platz zu schaffen, und welches vor der Verschiebung sowohl diejenigen im Schieberegister $a[]$ gespeicherten Daten bestimmt, welche verschoben werden sollen, als auch die Position im Schieberegister selektiert, an welche das neue Datum einsortiert wird.

Die erfindungsgemäße Vorrichtung und das ihm zugeordnete erfindungsgemäße Verfahren werden nachfolgend mit Hilfe von Figuren näher erläutert. Hierbei zeigt

Figur 1 den prinzipiellen Aufbau eines Rank Value Filters,

Figur 2 die Funktionsweise des erfindungsgemäßen Verfahrens,

und Figur 3 mögliche Ausgestaltung der erfindungsgemäßen Vorrichtung.

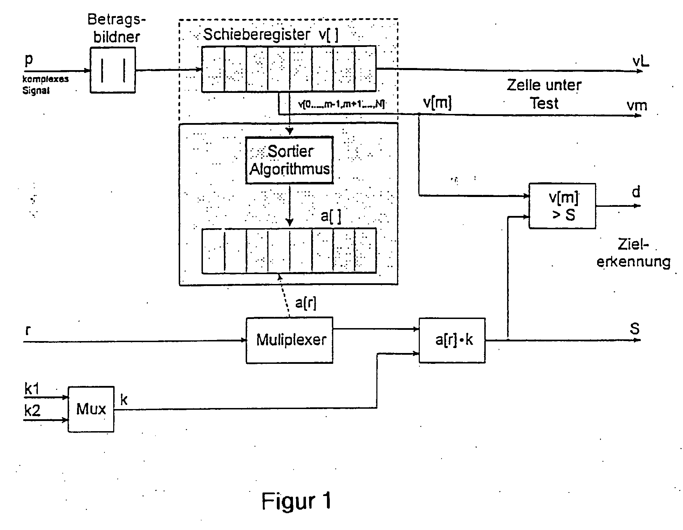

Der prinzipielle Aufbau und die Funktion eines Rank-Value-Filters soll anhand von Figur 1 aufgezeigt werden. Einzelne, von einem Detektor stammende Signalproben $p$ werden nach einer Betragsbildung in einem FIFO-Schieberegister $v[]$ (fist-in/first-out) zwischengespeichert. Dieses Schieberegister kann als Eingangsmodul eines sogenannten Median-Filters verstanden werden, mittels welchem die in $v[]$ enthaltenen Werte durch einen Sortieralgorithmus geordnet und in einem Schieberegister $a[]$ gespeichert werden. Der Begriff des Median-Filters rührt vom Ansatz des OS-CFAR her, welches darauf zielt, einen bestimmten Wert mit dem Rang $r$ als Schätzwert für den mittleren Störhintergrund zu verwenden. Hierzu wird aus der Menge von Zahlen die 'r-kleinste' ermittelt. Dies ist diejenige Zahl, welche an der r-ten Stelle in $a[]$ steht, wenn dort die Zahlen der Größe nach geordnet vorliegen.

Im Rahmen der Zielentdeckung wird nun an einer festgelegten Stelle (im allgemeinen der mittleren Speicherzelle) von $v[]$ der Wert eines Zielechos $p$ abgegriffen und einem Komparator zugeführt. Dort wird dieser Wert mit der Entdeckungsschwelle $S = a[r] \cdot k$ verglichen. Liegt der Wert des Zielechos oberhalb des Schwellwertes, so wird am Ausgang $d$ des Komparators die Meldung, daß ein Ziel detektiert wurde, ausgegeben.

Das zentrale Element der oben aufgezeigten Anordnung stellt das Rank-Value-Filter dar. Soll dieses in Echtzeit arbeiten, dann bedeutet dies, daß pro Taktzyklus eine neue Probe $p$ in das Schieberegister $v[]$ geschrieben und der zeitlich älteste Probewert verworfen werden muß. Um dies zu ermöglichen, ist das Rank-Value-Filter in einer für hohe Taktfrequenzen günstigen Architektur zu realisieren, welche auf einen hierfür geeigneten Algorithmus basiert. Der diesen Anforderungen entsprechende, erfindungsgemäße Algorithmus basiert auf der Methode des 'Löschen und Einfügen'. Hierbei werden Elemente innerhalb des vorsortierten Schieberegisters $a[]$ nach links oder rechts um eine Position verschoben. Das zeitlich älteste und deshalb zu löschende Element $vL$ wird hierbei durch seinen Nachbarn ersetzt und das zeitlich jüngste Element $vI$ an die richtige Position des vorsortierten Feldes in $a[]$ eingefügt. Die hierfür notwendigen Verfahrensschritte sind:

1. Die Bestimmung der Bewegungsrichtung des Schieberegisters ($LR$)

2. Die Markierung der aktiven Positionen ($EN$); d.h.: Die Markierung der Elemente die verschoben werden

3. Die Markierung der Position des einzufügenden Elements (*LOAD*)

Um den Verarbeitungsaufwand zu minimieren sollen nur diejenigen Elemente im Schieberegister $a$[] verschoben werden, deren Betrag zwischen $v$*l* und $v$*L* liegt ('aktive Positionen'). Die Schieberichtung (*LR*) wird aus dem Größenvergleich von $v$*l* und $v$*L* ermittelt, gemäß:

$$vL < vl \implies LR = 'links' \qquad\qquad Gl.1$$

$$vL > vl \implies LR = 'rechts' \qquad\qquad Gl.2$$

$$vL = vl \implies LR = 'Stillstand' \qquad\qquad Gl.3$$

Sind entsprechend Gl.3 die Werte von $v$*L* und $v$*l* identisch, dann ist kein weiterer Verfahrensschritt innerhalb des Rank Value Filters mehr notwendig, da das alte Element $v$*L* einer direkten Kopie des neuen Elements $v$*l* entspricht. Eine Umgruppierung des Sortierten Feldes $a$[] erübrigt sich somit.

Im zweiten Schritt des erfindungsgemäßen Verfahrens werden $v$*l* und $v$*L* unabhängig voneinander mit jedem Element des vorsortierten Feldes $a$[] verglichen. Dabei werden jeweils die drei Vektoren *B*(igger), *S*(maller) und *E*(qual) gebildet deren Dimension der von $a$[] entspricht. Das heißt, $v$*l* und $v$*L* werden mit jedem Wert von $a$[] gemäß den Gleichungen 4 bis 6 verglichen und für den Fall, daß das Resultat des Vergleichs zutrifft, wird die entsprechende Position s in einem der drei Vektoren *B, S* oder *E* auf 1 gesetzt.

$$V > a[] \implies B(igger) \qquad\qquad Gl.4$$

$$V < a[] \implies S(maller) \qquad\qquad Gl.5$$

$$V = a[] \implies E(qual) \qquad\qquad Gl.6$$

Um die Anzahl von notwendigen Vergleichen zur Bestimmung der Elemente der drei Vektoren *B, S* oder *E* zu reduzieren ist es auch denkbar nur 2 der drei Vektoren durch Vergleich mit dem vorsortierten Feld $a$[] zu bilden und zur Bildung des dritten verbleibenden Vektors die Beziehung

$$S(x) = \overline{B(x) \vee E(x)}, \qquad \text{wobei gilt } x = vL \text{ bzw. } vl \qquad Gl.7$$

heranzuziehen.

Zur Markierung der aktiven Positionen entsprechend des Verfahrensschrittes 2, dient der Vektor *EN,* welcher wie zuvor *B, S* und *E* in seiner Dimension $a$[] entspricht. Jedem korrespondierenden Element von $a$[] wird innerhalb *EN* eine 1 oder eine 0 zugeordnet, ganz entsprechend des Ergebnisses der boolschen Verknüpfungen Gl.8 bis Gl.10 und in Abhängigkeit der gemäß Gl.1 und 2 festgelegten Schieberichtung *LR*:

$$LR = links: \quad EN = (S(vL) \vee E(vL)) \wedge B(vl) \qquad Gl.8$$

$$LR = rechts: \quad EN = S(vl) \wedge (B(vL) \vee E(vL)) \qquad Gl.9$$

$$LR = Stillstand: \quad EN = E(vL) \qquad Gl.10$$

Der aus den Verknüpfungen Gl.8 bis Gl.10 resultierende Vektor *EN* wird im dritten Verfahrensschritt zur der Position *LOAD* des einzufügenden Elementes v*l* in *a*[] herangezogen. Nachfolgend ist in den boolschen Verknüpfungen Gl.11 bis Gl.13 und in Abhängigkeit der gemäß Gl.1 bis Gl.3 festgelegten Schieberichtung *LR* der Zusammenhang zwischen *EN* und *LOAD* dargelegt:

$$LR = links: \quad LOAD[i] = EN[i-1] \wedge EN[i] \wedge \overline{EN}[i+1] \qquad Gl.11$$

$$LR = rechts: \quad LOAD[i] = \overline{EN}[i-1] \wedge EN[i] \wedge EN[i+1] \qquad Gl.12$$

$$LR = Stillstand: \quad LOAD[i] = \overline{EN}[i-1] \wedge EN[i] \wedge \overline{EN}[i+1] \qquad Gl.13$$

wobei gilt: $0 \leq i \leq N$ mit $N$ = Anzahl von Elementen in $a[]$, sowie

$$EN[-1] = EN[N+1] = 0$$

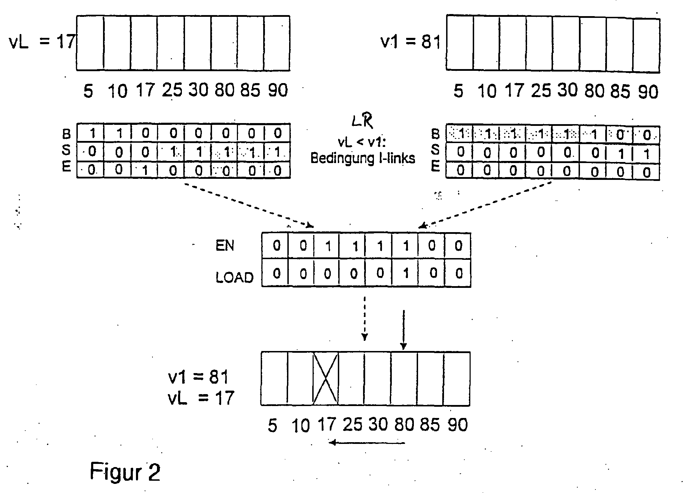

Figur 2 zeigt exemplarisch die Funktionsweise des erfindungsgemäßen Verfahrens auf. Angenommen sei hierbei, daß das Schieberegister *a*[] mit den nach ihrer Größe geordneten Werten 5, 10, 17, 25, 30, 80, 85 und 90 belegt sei. Der älteste der Werte v*L* weise den Wert 17 auf und der neu hinzukommende Wert v*l* soll den Wert 81 aufweisen. Gemäß den Gleichungen 1 bis 3 wird *LR* auf 'links' gesetzt. Auch werden entsprechend der Gleichungen 4 bis 7, jeweils unabhängig für v*L* und v*l*, die Vektoren *B, S* und *E* generiert. Entsprechend der Gleichung 8 und 11 (Boolsche Verknüpfungen für den Fall *LR*='links') können nun die mit den Elementen von *a*[] korrespondierenden Vektoren *EN* und *LOAD* generiert werden. Abhängig von der Bewegungsrichtung (hier: links) entspricht nun der zum ersten positiven Element in *EN* korrespondierende Wert in *a*[] dem Wert v*L*.
Ausgehend von diesem werden nun alle anschließenden zu einem positiven Wert in *EN* korrespondierenden Werte in *a*[] der Bewegungsrichtung *LR* entsprechend verschoben. Die Position des einzufügenden Elements (*LOAD*-Vektor) stimmt in Abhängigkeit der Bewegungsrichtung immer mit dem letzten positiven Element in *EN* überein.

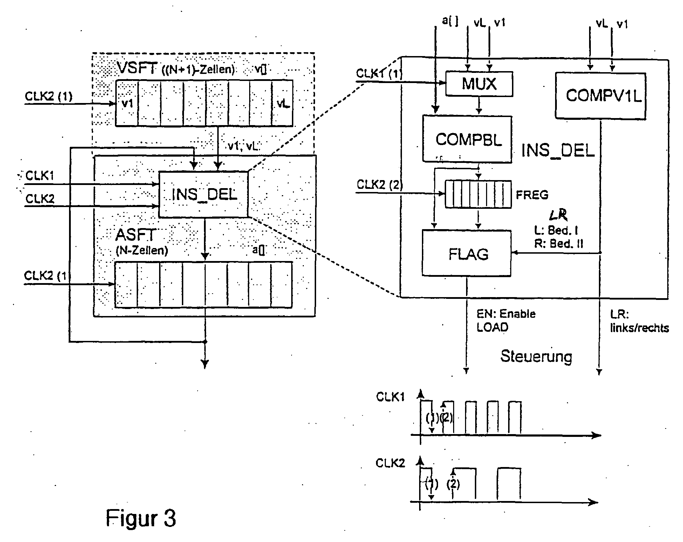

Figur 3 zeigt beispielhaft eine mögliche Architektur des Rank-Value-Filters. Das Filter ist hierarchisch aufgebaut und besteht auf oberster Ebene aus einem einfachen Shiftregister VSFT (V-Shift), dem Sortiermodul INS_DEL (Insert and_Delete) und dem komplexern rechts/links Shiftregister ASFT (A-Shift). ASFT entspricht der Schieberegistereinheit zur Speicherung des vorsortierten Feldes *a*[], während VSFT ein FIFO-Schieberegister zur Speicherung von *v*[] darstellt.
Das Sortiermodul INS_DEL innerhalb des Rank-Value-Filters ist so ausgelegt, daß es in der Lage ist in Echtzeit zu arbeiten. Es gliedert sich in der in Figur 3 dargestellten Ausführungsform in fünf Submodule (MUX, COMPV1L, COMPBL, FREG und FLAG) und wird über zwei Taktsignale CLK1 und CLK2 gesteuert. An seinem Eingang liegen der älteste sowie der jüngste der Signale Werte aus VSFT (v*L* und v*l*), sowie die der Inhalt des vorsortierten Schieberegisters ASFT (*a*[]) an. Am Ausgang liefert INS_DEL die Vektoren zur Steuerung der Neuordnung von ASFT. Die Funktionen der fünf Module aus denen INS_DEL aufgebaut ist, sowie typische Timing-Diagramme für die beiden Steuersignale CLK1 und CLK2 sind in Figur 3 dargestellt und wie folgt definiert:

1. Das Modul MUX ist ein einfacher Multiplexer, der bei einer fallenden Flanke von CLK1 zwischen $\nu L$ und $\nu I$ umschaltet.

2. Das Modul COMPV1L vergleicht $\nu I$ mit $\nu L$. Der Ausgang *LR* steuert alsdann die Bewegungsrichtung des Schieberegisters ASFT, als auch die Auswahl der Auswertelogik zur Bestimmung der *EN-* und *LOAD*-Vektoren innerhalb des Moduls FLAG, wie im nachfolgend noch näher erläutert.

3. Das Modul COMPBL besteht aus *N* Komparatoren, wobei *N* der Anzahl von Elementen entspricht, welche gemeinsam im Rank-Value-Filter verarbeitet werden (siehe auch Gleichung 11 bis 13). Das Modul vergleicht nacheinander das vorsortierte Feld ASFT mit $\nu L$ und $\nu I$. Die aus dem Vergleich resultierenden Ergebnisvektoren *B, S,* und *E* bestehen jeweils aus N Flags, entsprechend der in den Gleichungen 4 bis 7 definierten Verhältnisse zwischen $\nu L$ und $\nu I$.

4. Das Modul FREG dient als Zwischenspeicher für die in COMBL gewonnenen Vergleichsergebnisse von ASFT bezüglich $\nu L$ . Diese Zwischenspeicherung ist notwendig da die Verarbeitung der Eingangswerte $\nu L$ und $\nu I$ in COMBL nicht parallel sondern sequentiell erfolgt und alle Vergleichsergebnisse gemeinsam im nachfolgenden Modul benötigt werden.

5. Das Modul FLAG besteht aus der Auswertelogik, welche den boolschen Vergleichen für EN (Gl. 8 bis 10) und LOAD (Gl.11 bis 13) nachgebildet ist. An den Eingängen des Moduls FLAG liegen unmittelbar die in COMPBL generierten Vergleichsergebnisse bezüglich $\nu I$ und ASFT, sowie die in FREQ zwischengespeicherten in COMPBL generierten Vergleichsergebnisse bezüglich $\nu L$ und ASFT an. Der Ausgang von FLAG bildet einen der beiden Ausgänge von INS_DEL, an welchen die Vektoren zur Steuerung der Neuordnung von ASFT anliegen.

Den Systemtakt des Rank Value Filters bildet CLK1. Der Takt CLK2 weist in vorteilhafterweise die halbe Frequenz von CLK1 auf und wird mit vorzugsweise mittels eines Flip-Flops, welches als Frequenzteiler dient, generiert (Figur 3). Es ist jedoch auch denkbar die beiden Verarbeitungstakte CLK1 und CLK2 unabhängig voneinander laufen zu lassen. Sie sind nur in einer Weise zu synchronisieren, daß innerhalb des Moduls FLAG eine parallele Auswertung der im Modul FREG gespeicherten und der in COMPBL gewonnenen Vergleichsergebnisse ermöglicht wird.

In einer anderen denkbaren Ausführungsform der erfindungsgemäßen Vorrichtung ist das Sortiermodul INS_DEL innerhalb des Rank-Value-Filters so ausgelegt, daß es auf die Anordnung von drei Teilmodulen (COMPV1L, COMPBL und FLAG) reduziert und nur noch durch einen Verarbeitungstakt CLK1 gesteuert wird. Hierbei sind die 3 Teilmodule wie folgt definiert:

- das erste Modul COMPV1L ist ein Komparator, welcher $\nu I$ mit $\nu L$ vergleicht und dessen Ausgang *LR* die Bewegungsrichtung des Schieberegisters ASFT steuert und die Auswertelogik zur Bestimmung der *EN-* und *LOAD*-Vektoren innerhalb des Moduls FLAG, wie nachfolgend erläutert, selektiert.

- das zweite Modul COMPBL besteht aus zwei parallel geschalteten Teilmodulen, wobei jedes dieser Teilmodule aus *N* Komparatoren aufgebaut wird, wobei *N* der Anzahl von Elementen entspricht, welche gemeinsam im Rank-Value-Filter verarbeitet werden, und wobei an einem der Teilmodule $\nu L$ und an dem anderen $\nu I$ anliegt, so daß die Komparatoren in Folge von Vergleichen des vorsortierten Feldes ASFT mit $\nu L$ und $\nu I$ die Elemente der Zeigerregister *B, S,* und *E* bestimmen können.

- und das dritte Modul FLAG als Auswertelogik realisiert ist, an deren Eingang parallel die beiden in COMPBL gewonnenen Vergleichsergebnisse anliegen, wobei die Auswertelogik sich in zwei fall-spezifische Teile gegliedert und die Fallentscheidung durch den Ausgang *LR* des Moduls COMPV1L gesteuert wird, so daß der Ausgang von FLAG direkt an das Schieberegister ASFT gekoppelt ist, welches durch die in INS_DEL generierten Werte *LR, EN* und *LOAD* manipuliert wird.

Auf diese Weise verringert sich der notwendige Hardwareaufwand zur Realisierung von INS_DEL deutlich. Auch verdoppelt sich die mögliche Verarbeitungsgeschwindigkeit, da die Vergleichsergebnisse bezüglich $\nu L$ und $\nu I$ mit *a*[] parallel erzeugt werden, entgegen der in Figur 3 aufgezeigten sequentiellen Erzeugung. Vorteilhaft wirkt sich zudem aus, daß nur noch ein Taktsignal (CLK1) zur Steuerung des Moduls INS_DEL benötigt wird.

**Patentansprüche**

1. Verfahren zur schaltungstechnischen Realisierung eines Rank Value Filters, wobei ein neu hinzukommendes Datum mittels der Sortiermethode des 'Löschen und Einfügen' in ein der Größe nach vorsortiertes Datenfeld eingefügt wird und wobei die Schieberichtung bestimmt wird, in welche die im Schieberegister gespeicherten Daten geschoben werden, um für die Einsortierung eines neuen Datums Platz zu schaffen, wobei vor der Verschiebung der gespeicherten Daten diejenigen bestimmt werden, welche verschoben werden sollen, und wobei die Position im Schieberegister bestimmt wird, an welche das neue Datum einsortiert wird, **dadurch gekennzeichnet, daß**

- die Schieberichtung *LR* aus einem Größenvergleich des zeitlich jüngsten Datums v*l* mit dem zeitlich ältesten Datum v*L* ermittelt wird, gemäß der Regel:

$$vL < v1 \implies LR = \text{"}links\text{"}$$

$$vL > v1 \implies LR = \text{"}rechts\text{"}$$

$$vL = v1 \implies LR = \text{"}Stillstand\text{"}$$

- die Werte v*l* und v*L* mit jedem Datum des vorsortierten Datenfeldes *a*[] verglichen werden und daß dabei jeweils drei Vektoren *B, S* und *E* gebildet werden deren Dimension der von *a*[] entspricht, wobei für den Fall, daß das Resultat des Vergleichs zutrifft, die entsprechende Position in einem der drei Vektoren von 0 auf 1 gesetzt wird, wobei die durchzuführenden Vergleiche M wie folgt den Vektoren *B, S* und *E* zugeordnet sind:

$$V > a[] \implies B(igger)$$

$$V < a[] \implies S(maller)$$

$$V = a[] \implies E(qual)$$

- ein Vektor *EN* geschaffen wird, der in seiner Dimension *a*[] entspricht und daß jedem zu *a*[] korrespondierenden Datum von *EN* eine 1 oder 0 zugeordnet wird und daß die Zuordnung von dem Ergebnis einer von der Schieberichtung *LR* abhängigen boolschen Verknüpfung abhängt, gemäß:

$$LR = links: \quad EN = (S(vL) \vee E(vL)) \wedge B(v1)$$

$$LR = rechts: \quad EN = S(v1) \wedge (B(vL) \vee E(vL))$$

$$LR = Stillstand: \quad EN = E(vL)$$

- in Abhängigkeit von der Schieberichtung *LR* und den Daten von *EN* ein Vektor *LOAD* generiert wird, der in seiner Dimension *a*[] entspricht, und durch die nachfolgenden boolschen Gleichungen definiert ist:

$$LR = links: \quad LOAD[i] = EN[i-1] \wedge EN[i] \wedge \overline{EN[i+1]}$$

$$LR = rechts: \quad LOAD[i] = \overline{EN[i-1]} \wedge EN[i] \wedge EN[i+1]$$

$$LR = Stillstand: \quad LOAD[i] = \overline{EN[i-1]} \wedge EN[i] \wedge \overline{EN[i+1]}$$

wobei gilt:

$$0 \leq i \leq N$$

mit $N$ = Anzahl von Daten in a[], sowie

$$EN[-1] = EN[N+1] = 0,$$

so daß *LOAD* an der zu *a*[] korrespondierender Stelle, an welcher das neue Datum v*I* eingefügt werden soll, den Wert 1 aufweist.

2.  Verfahren nach Anspruch 1, **dadurch gekennzeichnet, daß** nur 2 der drei Vektoren *B, S* und *E* durch Vergleich mit dem vorsortierten Feld *a*[] gebildet werden, und dass zur Bildung des dritten verbleibenden Vektors die Beziehung

$$S(x) = \overline{B(x) \vee E(x)},$$

wobei *x* = v*L* bzw. v*I*, herangezogen wird.

3.  Vorrichtung zur schaltungstechnischen Realisierung eines Rank-Value-Filters,
    wobei das Rank-Value-Filter hierarchisch aufgebaut ist, und als zentrales Element ein Sortiermodul (INS_DEL) enthält,

    - welches über mindestens einen Steuereingang in seinem Verarbeitungstakt gesteuert wird,
    - an dessen Eingängen der Inhalt eines Schieberegisters (ASFT), welches die der Größe nach sortierten Daten enthält, sowie das jüngste Datum v*I* (einzusortierendes Datum) als auch das älteste Datum v*L* (zu löschendes Datum) anliegen,
    - und an dessen Ausgängen drei Signale *LR*, *EN* und *LOAD* zur Steuerung des Schieberegisters (ASFT) abgegriffen werden können, **dadurch gekennzeichnet, dass**
    sich das Sortiermodul (INS_DEL) in fünf Submodule gliedert, deren Verarbeitungstakt durch zwei Taktsignale CLK1 und CLK2 gesteuert wird, wobei
    - das erste Modul (MUX), aus einem einfachen Multiplexer besteht, der bei einer fallenden Flanke von CLK1 zwischen v*L* und v*I* umschaltet,
    - das zweite Modul (COMPV1L) ein Komparator ist, welcher v*I* mit v*L* vergleicht und dessen Ausgang (*LR*) die Bewegungsrichtung des Schieberegisters (ASFT) steuert und die Auswertelogik zur Bestimmung der *EN*- und *LOAD*-Vektoren innerhalb des fünften Moduls (FLAG), wie nachfolgend erläutert, selektiert;
    - das dritte Modul (COMPBL) aus *N* Komparatoren aufgebaut wird, wobei *N* der Anzahl von Daten entspricht, welche gemeinsam im Rank-Value-Filter verarbeitet werden,

    wobei die Komparatoren setzen in Folge von Vergleichen des vorsortierten Feldes (ASFT) mit v*L* und v*I* die Daten der Zeigerregister *B, S,* und *E*;

- das vierte Modul (FREG) ein Zwischenspeicher für die im dritten Modul (COMPBL) gewonnenen Vergleichsergebnisse des Schieberegisters (ASFT) bezüglich $\upsilon L$ ist;
- und das fünfte Modul (FLAG) als Auswertelogik realisiert ist, an deren Eingang parallel die im vierten Modul (FREG) gespeicherten Werte, als auch die im dritten Modul (COMPBL) gewonnenen Vergleichsergebnisse anliegen, wobei die Auswertelogik in zwei fall-spezifische Teile gegliedert ist, wobei die Fallentscheidung durch den Ausgang $LR$ des Moduls (COMPV1L) gesteuert wird und wobei an den Ausgang des fünften Moduls (FLAG) direkt das Schieberegister (ASFT) gekoppelt ist, welches durch die im Sortiermodul (INS_DEL) generierten Werte $LR$, $EN$ und $LOAD$ manipuliert wird.

4. Vorrichtung nach Anspruch 3, **dadurch gekennzeichnet, daß** der zur Steuerung des Sortiermoduls (INS_DEL) verwendete Takt CLK2 an den Zwischenspeicher (FREG) angelegt ist.

5. Vorrichtung nach einem der Ansprüche 3 oder 4, **dadurch gekennzeichnet, daß** die Erzeugung des Taktes CLK2 direkt an den ebenfalls zur Steuerung des Sortiermoduls (INS_DEL) herangezogenen Systemtaktes CLK1 gekoppelt ist.

6. Vorrichtung nach Anspruch 5, **dadurch gekennzeichnet, daß** CLK2 mittels eines Flip-Flops von CLK1 abgeleitet wird.

7. Vorrichtung nach einem der Ansprüche 3 bis 6, **dadurch gekennzeichnet, daß** die Kopplung zwischen CLK1 und CLK2 so gestaltet wird, daß eine steigende Flanke von CLK2 annähernd gleichzeitig mit einer fallenden Flanke von CLK1 zusammenfällt.

8. Vorrichtung nach Anspruch 3, **dadurch gekennzeichnet, daß** sich das Sortiermodul in drei Submodule gliedert, deren Verarbeitungstakt durch ein Taktsignal CLK1 gesteuert wird, wobei

- das erste Modul (COMPV1L) ein Komparator ist, welcher $\upsilon l$ mit $\upsilon L$ vergleicht und dessen Ausgang $LR$ die Bewegungsrichtung des Schieberegisters (ASFT) steuert und die Auswertelogik zur Bestimmung der $EN$- und $LOAD$-Vektoren innerhalb des dritten Moduls (FLAG), wie nachfolgend erläutert, selektiert;
- das zweite Modul (COMPBL) aus zwei parallel geschalteten Teilmodulen besteht, wobei jedes dieser Teilmodule aus $N$ Komparatoren aufgebaut wird, wobei $N$ der Anzahl von Daten entspricht, welche gemeinsam im Rank-Value-Filter verarbeitet werden, und wobei an einem der Teilmodule $\upsilon L$ und an dem anderen $\upsilon l$ anliegt, so daß die Komparatoren in Folge von Vergleichen des vorsortierten Feldes (ASFT) mit $\upsilon L$ und $\upsilon l$ die Daten der Zeigerregister $B$, $S$, und $E$ bestimmen können;
- und das dritte Modul (FLAG) als Auswertelogik realisiert ist, an deren Eingang parallel die beiden im zweiten Modul (COMPBL) gewonnenen Vergleichsergebnisse anliegen, wobei die Auswertelogik sich in zwei fall-spezifische Teile gegliedert und die Fallentscheidung durch den Ausgang $LR$ des ersten Moduls (COMPV1L) gesteuert wird, so daß der Ausgang des dritten Moduls (FLAG) direkt an das Schieberegister (ASFT) gekoppelt ist, welches durch die im Sortiermodul (INS_DEL) generierten Werte $LR, EN$ und $LOAD$ manipuliert wird.

**Claims**

1. Method for circuitry implementation of a rank value filter, a newly added data item being inserted by means of the sorting method of "delete and insert" into a data field presorted in accordance with size, the shift direction being determined in which the data stored in the shift register are shifted in order to create space for sorting a new data item, before the shifting of the stored data those data being determined which are to be shifted, and the position in the shift register being determined at which the new data item is sorted, **characterized in that**

- the shift direction $LR$ is determined by comparing the size of the temporally earliest data item $\upsilon l$ with the temporally latest data item $\upsilon L$ in accordance with the rule:

$$\upsilon L < \upsilon l \implies LR = \text{``left''}$$

$$\upsilon L > \upsilon l \implies LR = \text{``right''}$$

$$\upsilon L = \upsilon l \implies LR \text{ ``standstill''},$$

- the values $\upsilon l$ and $\upsilon L$ are compared with each data item of the presorted data field $a[]$,
and **in that** in this case three vectors $B$, $S$ and $E$ are respectively formed whose dimension corresponds to that of $a[]$, the corresponding position in one of the three vectors being set from 0 to 1 in the case where the result of the comparison is correct, the comparisons ($v$) to be carried out being assigned to the vectors $B$, $S$ and $E$ as follows:

$$V > a[] \implies B(igger)$$

$$V < a[] \implies S(maller)$$

$$V = a[] \implies E(qual)$$

- a vector $EN$ is created whose dimension corresponds to $a[]$, and **in that** each data item of $EN$ corresponding to $a[]$ is assigned a 1 or 0, and **in that** the assignment is a function of the result of a Boolean operation dependent on the shift direction $LR$, in accordance with:

$$LR = left: \quad EN = (S(\upsilon L) \lor E(\upsilon L)) \land B(\upsilon l)$$

$$LR = right: \quad EN = S(\upsilon l) \land (B(\upsilon L) \lor E(\upsilon L))$$

$$LR = standstill: \quad EN = E(\upsilon L)$$

- as a function of the shift direction $LR$ and of the data of $EN$ a vector $LOAD$ is generated whose dimension corresponds to $a[]$, and which vector is defined by the following Boolean equations:

$$LR = left: \quad LOAD[i] = EN[i-1] \land EN[i] \land \overline{EN}[i+1]$$

$$LR = right: \quad LOAD[i] = \overline{EN}[i-1] \land EN[i] \land EN[i+1]$$

$$LR = standstill: LOAD[i] = \overline{EN}[i-1] \land EN[i] \land \overline{EN}[i+1]$$

where it holds that:

$$0 \le i \le N$$

with N = number of data in a[], and

$$EN[-1] = EN[N+1] = 0$$

9

such that *LOAD* has the value 1 at the point corresponding to *a*[] at which the new data item $\upsilon l$ is to be inserted.

2. Method according to Claim 1, **characterized in that** only 2 of the three vectors *B, S* and *E* are formed by comparison with the presorted field *a*[], and **in that** the relationship

$$S(x) = \overline{B(x) \lor E(x)}, \quad \text{in which } x = \upsilon L \text{ or } \upsilon l,$$

is used to form the third remaining vector.

3. Device for circuitry implementation of a rank value filter, the rank value filter being hierarchically structured and including as central element a sorting module (INS_DEL)

   - whose processing clock is controlled via at least one control input,
   - at whose inputs there lie the contents of a shift register (ASFT) which contains the data sorted for size, as well as the earliest data item $\upsilon l$ (data item to be sorted) and the latest data item $\upsilon L$ (data item to be deleted),
   - and at whose outputs it is possible to tap off three signals *LR, EN* and *LOAD* in order to control the shift register (ASFT), **characterized in that** the sorting module (INS_DEL) is divided into five submodules whose processing clock is controlled by two clock signals CLK1 and CLK2, wherein
   - the first module (MUX) consists of a simple multiplexer which switches over between $\upsilon L$ and $\upsilon l$ in the case of a falling edge of CLK1,
   - the second module (COMPV1L) is a comparator which compares $\upsilon l$ with $\upsilon L$ and whose output (*LR*) controls the movement direction of the shift register (ASFT) and selects the evaluation logic for determining the *EN* vectors and *LOAD* vectors inside the fifth module (FLAG) as explained below;
   - the third module (COMPBL) is constructed from *N* comparators, *N* corresponding to the number of data items which are processed together in the rank value filter, the comparators setting the data of the pointer registers *B, S* and *E* as a consequence of comparing the presorted field (ASFT) with $\upsilon L$ and $\upsilon l$;
   - the fourth module (FREG) is a buffer for the comparison results, obtained in the third module (COMPBL) of the shift register (ASFT) with reference to $\upsilon L$;
   - and the fifth module (FLAG) is implemented as an evaluation logic at whose input are present in parallel the values stored in the fourth module (FREG) as well as the comparison results obtained in the third module (COMPBL), the evaluation logic being divided into two case-specific parts, the case decision being controlled by the output *LR* of the module (COMPV1L), and there being connected directly to the output of the fifth module (FLAG) the shift register (ASFT) which is manipulated by the values *LR, EN* and *LOAD* generated in the sorting module (INS_DEL).

4. Device according to Claim 3, **characterized in that** the clock CLK2 used to control the sorting module (INS_DEL) is applied to the buffer (FREG).

5. Device according to either of Claims 3 or 4, **characterized in that** the generation of the clock CLK2 is coupled directly to the system clock CLK1 likewise used to control the sorting module (INS_DEL).

6. Device according to Claim 5, **characterized in that** CLK2 is derived from CLK1 by means of a flip flop.

7. Device according to one of Claims 3 to 6, **characterized in that** the coupling between CLK1 and CLK2 is fashioned such that a rising edge of CLK2 coincides approximately simultaneously with a falling edge of CLK1.

8. Device according to Claim 3, **characterized in that** the sorting module is divided into three submodules whose processing clock is controlled by a clock signal CLK1, wherein

   - the first module (COMPV1L) is a comparator which compares $\upsilon l$ with $\upsilon L$ and whose output (*LR*) controls the movement direction of the shift register (ASFT) and selects the evaluation logic for determining the *EN* vectors and LOAD vectors inside the third module (FLAG) as explained below;
   - the second module (COMPBL) consists of two submodules, connected in parallel, each of these submodules being constructed from *N* comparators, *N* corresponding to the number of data which are processed together in the rank value filter, and $\upsilon L$ being present at one of the submodules and $\upsilon l$ being present at the other such that the comparators can determine the data of the pointer registers *B, S* and *E* as a consequence of comparing the presorted field (ASFT) with υ*L* and υ*l*;

- and the third module (FLAG) is implemented as an evaluation logic at whose input the two comparison results obtained in the second module (COMPBL) are present in parallel, the evaluation logic being divided into two case-specific parts and the case decision being controlled by the output *LR* of the first module (COMPV1L) such that the output of the third module (FLAG) is coupled directly to the shift register (ASFT) which is manipulated by the values *LR, EN* and *LOAD* generated in the sorting module (INS_DEL).

**Revendications**

1. Procédé de réalisation d'un filtre de n-ième rang, dans lequel une nouvelle donnée entrante est insérée dans le champ de données pré-trié en fonction de sa taille au moyen de la méthode de tri de « l'effacement et insertion » et dans lequel la direction de décalage est déterminée, dans laquelle les données mémorisées dans le registre de décalage sont décalées, afin de libérer de la place pour le rangement d'une nouvelle donnée, dans lequel avant le décalage des données mémorisées il est déterminé lesquelles doivent être décalées, et dans lequel la position dans le registre de décalage est déterminée, à laquelle la nouvelle donnée doit être rangée, **caractérisé en ce que**

- la direction de décalage LR est déterminée d'après une comparaison de grandeur de la donnée la plus récente temporellement v1 avec la données la plus ancienne temporellement vL, conformément à la règle :

```
vL < v1 => LR = « gauche »
```

```
vL > v1 => LR = « droite »
```

```
vL = v1 => LR = « arrêt »
```

- les valeurs v1 et vL sont comparées avec chaque donnée du champ de données pré-trié a[] et respectivement trois vecteurs B, S et E sont formés, dont les dimensions correspondent à celles de a[] ; moyennant quoi au cas où le résultat de la comparaison est exact, la position correspondante dans un des trois vecteurs est décalée de 0 à 1, les comparaisons (V) à effectuer étant coordonnées de la manière suivante aux vecteurs B,S et E :

```
V > a[] => B(igger)
```

```
V < a[] => S(maller)
```

```
V = a [] => E(qual)
```

- un vecteur EN est créé, qui correspond à a[] dans ses dimensions et chaque donnée de EN correspondant à a[] est attribuée à 1 ou 0 et l'attribution dépend du résultat d'une mise en relation booléenne fonction de la direction de décalage LR, conformément à :

```
LR = gauche : EN = (S(vL)v E(vL) ^ B(v1)
```

```
LR = droite : EN = S(v1)^ (B(vL) v E(vL))
```

```
LR = arrêt : EN = E(vL)
```

- en fonction de la direction de décalage LR et des données de EN, un vecteur LOAD est généré, lequel correspond dans sa dimension à a[] et qui est défini par les équations booléennes suivantes :

$$\texttt{LR} \quad = \quad \texttt{gauche :} \quad \texttt{LOAD[i]=EN[i-1]^\wedge} \quad \texttt{EN[i]}^\wedge$$
$$\overline{\texttt{EN}}\texttt{[i+1]}$$

$$\texttt{LR} \quad = \quad \texttt{droite :} \quad \texttt{LOAD[i]} \quad = \quad \overline{\texttt{EN}}\texttt{[i-1]}^\wedge\overline{\texttt{EN[i]}}^\wedge$$
$$\texttt{EN[i+1]}$$

$$\texttt{LR} \quad = \quad \texttt{arrêt :} \quad \texttt{LOAD[i]} \quad = \quad \overline{\texttt{EN}}\texttt{[i-1]}^\wedge \quad \texttt{EN[i]}^\wedge$$
$$\overline{\texttt{EN}}\texttt{[i+1]}$$

où il convient que : 0≤i≤N avec N= nombre de données dans a[] ainsi que

$$\texttt{EN[-1]} \quad = \quad \texttt{EN[N+1]} \quad = \quad \texttt{0,}$$

de sorte que LOAD présente à l'emplacement correspondant à a[], auquel la nouvelle donnée doit être insérée, la valeur 1.

2. Procédé selon la revendication 1, **caractérisé en ce que** seuls 2 des trois vecteurs B, S et E sont formés par la comparaison avec le champ a[] pré-trié et **en ce que**, afin de former le troisième vecteur restant, la relation

$$\texttt{S(x)} \quad = \quad \overline{\texttt{B(x)} \vee \texttt{E(x)}}\texttt{,}$$

où x= vL ou v1, est utilisée.

3. Dispositif de réalisation d'un filtre de n-ième rang, dans lequel le filtre de n-ième rang est structuré hiérarchiquement et contient comme élément central un module de tri (INS_DEL),

- lequel est commandé dans sa synchronisation de traitement par au moins une entrée de commande,
- aux entrées duquel sont présents le contenu d'un registre de décalage (ASFT), qui contient des données triées en fonction de leur taille ainsi que la donnée la plus récente v1 (donnée à ranger) et également la donnée la plus ancienne vL (donnée à effacer),
- et aux sorties duquel, trois signaux LR, EN et LOAD de commande du registre de décalage (ASFT) peuvent être prélevées, **caractérisé en ce que** le module de tri (INS_DEL) est divisé en cinq sous-modules, dont la synchronisation de traitement est commandée par deux signaux d'horloge CLK1 et CLK2, moyennant quoi
- le premier module (MUX) est constitué d'un multiplexeur simple, qui commute en présence d'un flanc descendant de CLK1 entre vL et v1,
- le deuxième module (COMPV1L) est un comparateur, qui compare v1 avec vL et dont la sortie (LR) commande la direction de mouvement du registre de décalage (ASFT) et sélectionne la logique d'évaluation pour déterminer les vecteurs EN et LOAD à l'intérieur du cinquième module (FLAG), comme cela sera expliqué par la suite ;
- le troisième module (COMPBL) est composé de N comparateurs, moyennant quoi N correspond au nombre de données, qui sont traitées en commun dans le filtre de n-ième rang, moyennant quoi les comparateurs donnent à la suite de comparaisons du champ pré-trié (ASFT) avec vL et v1 les données du registre de pointeur B, S et E ;
- le quatrième module (FREG) est une mémoire intermédiaire des résultats de comparaison du registre de décalage (ASFT) par rapport à vL obtenus dans le troisième module (COMPBL) ;
- et le cinquième module (FLAG) est réalisé comme une logique d'évaluation, à l'entrée de laquelle les valeurs mémorisées dans le quatrième module (FREG) ainsi que les résultats de comparaison obtenus dans le troisième module (COMPBL) sont présents en parallèle, moyennant quoi la logique d'évaluation est divisée en deux parties spécifiques à un cas, la décision du cas étant commandée par la sortie LR du module (COMPV1L), la sortie du cinquième module (FLAG) étant directement couplée au registre de décalage (ASFT), qui est manipulé par les valeurs LR, EN et LOAD générées dans le module de tri (INS_DEL).

4. Dispositif selon la revendication 3, **caractérisé en ce que**, le signal d'horloge CLK2 utilisé pour commander le module de tri (INS_DEL) est déposé dans la mémoire intermédiaire (FREG).

5. Dispositif selon une des revendications 3 ou 4, **caractérisé en ce que** la génération du signal d'horloge CLK2 est couplée directement à la synchronisation de système CLK1 également utilisé pour commander le module de tri (INS_DEL).

6. Dispositif selon la revendication 5, **caractérisé en ce que** CLK2 est dérivé de CLK1 au moyen d'une bascule.

7. Dispositif selon une des revendications 3 à 6, **caractérisé en ce que** le couplage entre CLK1 et CLK2 est conçu de telle sorte qu'un flanc montant de CLK2 coïncide à peu près simultanément avec un flanc descendant de CLK1.

8. Dispositif selon la revendication 3, **caractérisé en ce que** le module de tri est divisé en trois sous-modules, dont la synchronisation de traitement est commandée par un signal d'horloge CLK1, dans lequel

   - le premier module (COMPV1L) est un comparateur, qui compare v1 avec vL et dont la sortie LR commande la direction de mouvement du registre de décalage (ASFT) et sélectionne la logique d'évaluation pour déterminer les vecteurs EN et LOAD à l'intérieur du troisième module (FLAG), comme cela sera expliqué par la suite ;
   - le deuxième module (COMPBL) est constitué de deux modules partiels branchés en parallèle, moyennant quoi chacun de ces modules partiels est composé de N comparateurs, moyennant quoi N correspond au nombre de données, qui sont traitées en commun dans le filtre de n-ième rang et moyennant quoi vL est présent au niveau d'un des modules partiels et v1 au niveau de l'autre, de telle sorte que les comparateurs puissent déterminer, à la suite de comparaisons du champ pré-trié (ASFT) avec vL et v1, les données du registre de pointeur B, S et E ;
   - le troisième module (FLAG) est réalisé comme une logique d'évaluation, à l'entrée de laquelle les deux résultats de comparaison obtenus dans le deuxième module (COMPBL) sont présents en parallèle, moyennant quoi la logique d'évaluation est divisée en deux parties spécifiques à un cas et la décision du cas est commandée par la sortie LR du premier module (COMPV1L).

Betragsbildner

Schieberegister v[ ]

p

komplexes
Signal

| | | vL

v[0,...,m-1,m+1,...,N]

Zelle unter
Test

v[m]

vm

Sortier
Algorithmus

a[ ]

v[m]
> S

d

Zielerkennung

a[r]

r

Muliplexer

a[r]·k

S

k1
k2

Mux

k

# Figur 1

vL = 17

| | | | | | | | | |
|---|---|---|---|---|---|---|---|---|

5  10  17  25  30  80  85  90

v1 = 81

| | | | | | | | | |
|---|---|---|---|---|---|---|---|---|

5  10  17  25  30  80  85  90

*LR*

vL < v1:
Bedingung l-links

|   |   |   |   |   |   |   |   |   |
|---|---|---|---|---|---|---|---|---|
| B | 1 | 1 | 0 | 0 | 0 | 0 | 0 | 0 |
| S | 0 | 0 | 0 | 1 | 1 | 1 | 1 | 1 |
| E | 0 | 0 | 1 | 0 | 0 | 0 | 0 | 0 |

|   |   |   |   |   |   |   |   |   |
|---|---|---|---|---|---|---|---|---|
| B | 1 | 1 | 1 | 1 | 1 | 1 | 0 | 0 |
| S | 0 | 0 | 0 | 0 | 0 | 0 | 1 | 1 |
| E | 0 | 0 | 0 | 0 | 0 | 0 | 0 | 0 |

|       |   |   |   |   |   |   |   |   |
|-------|---|---|---|---|---|---|---|---|
| EN    | 0 | 0 | 1 | 1 | 1 | 1 | 0 | 0 |
| LOAD  | 0 | 0 | 0 | 0 | 0 | 1 | 0 | 0 |

v1 = 81
vL = 17

| | | ✕ | | | | | | |
|---|---|---|---|---|---|---|---|---|

5  10  17  25  30  80  85  90

Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

*   US 4649394 A